# DEMANDE DE BREVET EUROPEEN

(11) **EP 1 601 010 A2**
(43) Date de publication de la demande: **30.11.2005**
(21) Numéro de dépôt: 05104486.5
(22) Date de dépôt: 25.05.2005
(51) Int. Cl.: H01L 21/308, H01L 21/033, H01L 21/762, H01L 21/768, H01L 29/861

(54) **Formation de tranchées obliques**

(30) Priorité: 26.05.2004 FR 0451038
(71) Demandeur: ST MICROELECTRONICS S.A., 92120 Montrouge (FR)
(72) Inventeur: Boufnichel, Mohamed, 37100, Tours (FR); Bellières, Laurent, 37100, Tours (FR)
(74) Mandataire: de Beaumont, Michel

(57) **Abrégé**

L'invention concerne un procédé de formation d'un évidement oblique (21) de dimension minimale inférieure à 10 µm dans une plaquette disposée dans un réacteur de gravure plasma dans lequel le plasma s'étend le long de la surface de plaquette, consistant à former des discontinuités dans le contour du plasma et de sa gaine au voisinage immédiat de la plaquette dans des zones où l'on souhaite former des évidements délimités par des ouvertures (13) dans un masque de protection (12) à la surface de la plaquette.

## Description

### Domaine de l'invention

La présente invention concerne la réalisation d'évidements, perçages ou tranchées dans un matériau, et s'applique notamment au domaine des matériaux semiconducteurs, destinés à la réalisation de composants électroniques discrets ou intégrés.

L'invention concerne plus particulièrement la réalisation d'évidements, perçages ou tranchées obliques par rapport à une surface principale du matériau à graver et ayant une dimension transverse petite.

### Exposé de l'art antérieur

Quand on veut graver des évidements selon un motif dont au moins une dimension est très petite (inférieure à 10 µm et éventuellement inférieure à 1 µm) dans la surface d'un matériau, l'un des procédés couramment utilisés, notamment dans le domaine de la microélectronique, est un procédé de gravure plasma.

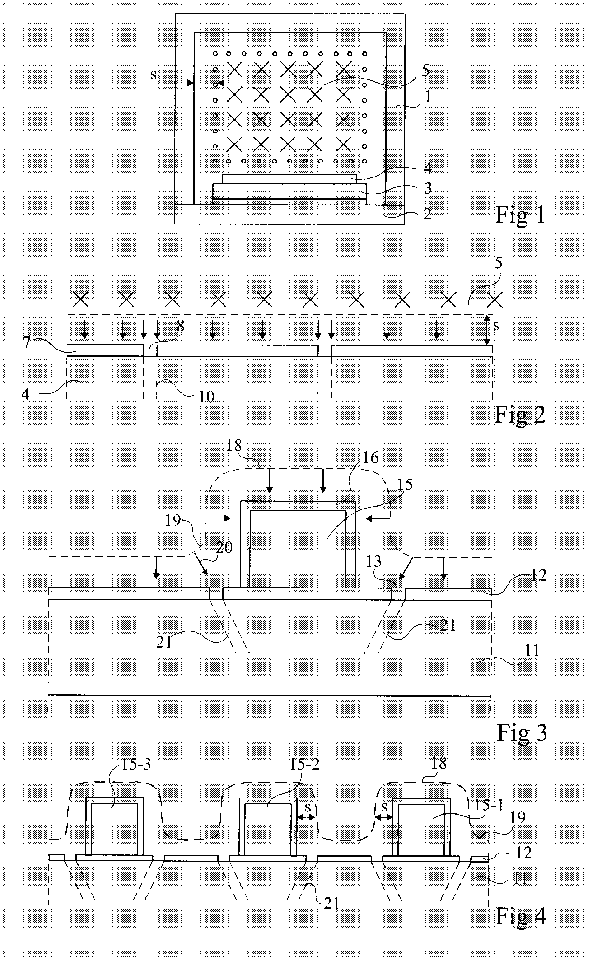

La figure 1 illustre très schématiquement un réacteur de gravure plasma. Le réacteur comprend une enceinte 1 munie d'un fond 2 sur lequel est placé un support ou suscepteur 3, qui peut être isolé du fond 2. Une plaquette 4 dans laquelle on veut effectuer des opérations de gravure est placée sur le support 3. Un plasma 5 est créé par tout moyen dans l'enceinte, par exemple par un champ radiofréquence, et peut être confiné par des champs électromagnétiques. Bien entendu, l'enceinte comprend en outre des moyens, non représentés, d'introduction, de circulation et d'extraction de gaz, et éventuellement des moyens de mise en température, par exemple de refroidissement, du support 3 ainsi que des moyens de polarisation de ce support. Comme l'illustre schématiquement la figure 1, le plasma s'étend généralement dans toute l'enceinte, et en tout cas au voisinage de la plaquette à graver 4, et est séparé de toutes les surfaces internes de l'enceinte par une distance s, dans laquelle il existe une zone neutre, appelée gaine. Dans le cas où la plaquette 4 est une plaquette de silicium, les plasmas sont souvent réalisés à partir de gaz fluorés ou chlorés.

De façon générale, les procédés de gravure plasma anisotrope font intervenir deux mécanismes : un mécanisme de gravure et un mécanisme de passivation qui peuvent être alternés ou non. On considère que le mécanisme de gravure fait intervenir deux phénomènes, d'une part un bombardement par les ions se trouvant dans le plasma, d'autre part une attaque chimique par des substances réactives se trouvant dans le plasma. Ces deux phénomènes sont indissociables. Le bombardement ionique est utilisé pour éliminer les produits de réaction disposés au fond d'un évidement en cours de formation.

Ces explications ont été données pour situer le contexte de la présente invention, étant entendu que les procédés de gravure par plasma sont bien connus en eux-mêmes et qu'il en existe de très nombreuses variantes qui pourront être trouvées dans les ouvrages spécialisés.

La figure 2 est une vue en coupe d'une plaquette 4, revêtue d'une couche de masquage 7 comprenant des ouvertures 8, disposée dans le réacteur de gravure plasma de la figure 1, c'est-à-dire que l'on retrouve une région de plasma 5 séparée de la plaquette par une épaisseur de gaine s.

Les ions bombardent la plaquette de silicium normalement à la surface de celle-ci et sont actifs, avec des espèces chimiques se trouvant dans le plasma, au niveau des ouvertures 8 dans le masque 7 pour graver dans la plaquette 4 des évidements 10 orthogonaux à la surface de la plaquette.

Ainsi, les techniques de gravure plasma anisotrope ne permettent normalement pas de réaliser des évidements non orthogonaux à une surface principale d'une plaquette à traiter.

La demande de brevet japonais 2002-134470 propose de dévier des ions grâce à un champ latéral créé au niveau de la surface d'une plaquette. Ce champ résulte d'une accumulation de charge sous des isolants d'épaisseurs différentes, la différence d'épaisseur étant de l'ordre de 100 nm. Il est peu probable que ce procédé permette d'obtenir des tranchées profondes ni d'obtenir des angles d'inclinaison de valeurs notables.

Ainsi, si on veut réaliser des évidements ou tranchées obliques, on utilise des techniques autres que de gravure plasma. Une tranchée oblique sera par exemple réalisée à la scie diamantée (JP-A-56054066), par sablage (JP-A-03225961), au laser (EP-A-0070692) ou encore par gravure ionique oblique (JP-A-08130220 et JP-A-62173737). Ces divers procédés ne permettent pas d'obtenir des tranchées fines et/ou de réaliser des motifs de forme complexe.

### Résumé de l'invention

La présente invention propose une modification des procédés habituels de gravure plasma pour permettre d'obtenir des évidements, tranchées ou vias s'étendant obliquement par rapport à la surface d'une plaquette et non pas seulement perpendiculairement à celle-ci, ces évidements pouvant avoir de petites dimensions latérales, telles qu'obtenues classiquement par gravure plasma.

Plus particulièrement, la présente invention prévoit un procédé de formation d'un évidement oblique de dimension minimale inférieure à 10 µm dans une plaquette disposée dans un réacteur de gravure plasma dans lequel le plasma s'étend le long de la surface de la plaquette, consistant à former des discontinuités dans le contour du plasma et de sa gaine au voisinage immédiat de la plaquette dans des zones où l'on souhaite former des évidements délimités par des ouvertures dans un masque de protection à la surface de la plaquette. Les discontinuités résultent par exemple de protubérances formées sur la plaquette.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente très schématiquement un réacteur de gravure plasma ;
la figure 2 est une vue en coupe d'une plaquette gravée par plasma de façon classique ;
la figure 3 est une vue en coupe d'une plaquette gravée par plasma selon un premier mode de réalisation de la présente invention ;
la figure 4 est une vue en coupe d'une plaquette gravée par plasma selon un deuxième mode de réalisation de la présente invention ;
la figure 5 représente une diode à isolement par tranchée formée de façon classique ; et
la figure 6 représente une diode à isolement par tranchée formée selon la présente invention.

Par souci de clarté, de mêmes éléments ont été désignés par de mêmes références aux différentes figures et, comme cela est habituel dans la représentation des éléments semiconducteurs, les diverses figures ne sont pas tracées à l'échelle.

### Description détaillée

La présente invention se base sur l'observation selon laquelle, dans un procédé classique de gravure plasma, la gravure est bien entendu orthogonale à la surface de la plaquette à graver mais surtout qu'elle se produit perpendiculairement à la surface du plasma à la limite de la gaine.

Ainsi, la présente invention propose de déformer le contour du plasma de sorte que des ions, projetés orthogonalement à ce contour, seront projetés dans une direction non parallèle à la surface de la plaquette.

Selon un mode de réalisation de l'invention, cette déformation du contour du plasma est réalisée en formant des protubérances sur la surface de la plaquette. Toutefois, d'autres moyens pourraient être envisagés pour déformer ce contour du plasma.

La figure 3 illustre un mode de réalisation de la présente invention. Sur une plaquette de silicium 11 à traiter est formé un masque 12 muni d'ouvertures 13. Au voisinage d'au moins une de ces ouvertures, on forme une protubérance 15 sur la plaquette. Cette protubérance peut être réalisée par dépôt et gravure d'une couche épaisse et sa surface sera éventuellement munie d'un revêtement 16 pour la rendre insensible à la gravure par le plasma.

Le contour du plasma se déforme au voisinage de la protubérance, comme cela est indiqué par la courbe en pointillés 18 et comporte notamment une zone arrondie 19 au voisinage des pieds de la protubérance. Dans la zone de courbure, les trajets 20 de bombardement ionique sont orthogonaux à cette courbure, c'est-à-dire présentent une oblicité par rapport à la surface de la plaquette 11. On pourra ainsi former des évidements obliques 21 dans la plaquette. L'inclinaison des évidements 21 dépend de la proximité des ouvertures 13 dans le masque 12 par rapport au pied de la protubérance 15. Plus les ouvertures 13 dans le masque 12 sont proches du pied de la protubérance 15, plus les évidements seront obliques.

Comme le représente la figure 4, dans laquelle de mêmes éléments sont désignés par de mêmes références qu'en figure 3, on pourra créer plusieurs protubérances 15.1, 15.2, 15.3 à la surface de la plaquette et créer divers évidements obliques aux pieds de ces protubérances, d'un côté et/ou de l'autre de chaque protubérance, ce qui permet d'orienter les évidements dans des directions différentes.

La distance entre les protubérances 15.1 et 15.2 est suffisante pour que la gaine soit déformée et que le plasma pénètre plus ou moins profondément entre les protubérances, c'est-à-dire que la distance entre deux protubérances doit être supérieure à l'épaisseur de gaine s.

En pratique, l'épaisseur de gaine a couramment, selon les conditions du plasma, une valeur de 0,1 à 0,6 mm. Ces valeurs ne sont données qu'à titre d'exemple et dépendront des conditions du plasma dans le réacteur ainsi que du type de réacteur. Notamment, on augmente l'épaisseur de gaine s en augmentant la pression dans l'enceinte. Ainsi, pour obtenir une déformation sensible de la forme de la gaine, il faut prévoir des protubérances d'une hauteur d'au moins 100 µm, de préférence de même ordre d'épaisseur que l'épaisseur s de la gaine.

Toutes les variantes de gravure plasma pourront être utilisées, notamment divers systèmes de polarisation du substrat et divers systèmes de refroidissement éventuels du substrat ainsi que divers systèmes de circulation des gaz dans l'enceinte.

De nombreux moyens pourront être utilisés pour réaliser la structure comportant les protubérances. Dans le cas où le substrat à graver est une plaquette de silicium, on pourra dans un premier temps revêtir cette plaquette d'un masque, puis poser sur la première plaquette une deuxième plaquette de silicium munie de perçages autour des protubérances 15 des figures 3 et 4. Les surfaces apparentes de la deuxième plaquette seront de préférence oxydées pour éviter une gravure du silicium par le plasma. On pourra, si l'on veut former dans la plaquette à graver plusieurs tranchées voisines et/ou d'orientations différentes, utiliser successivement plusieurs deuxièmes plaquettes comportant des motifs choisis.

De façon générale, l'invention présente l'avantage de permettre de former dans une plaquette des évidements, vias ou tranchées obliques d'une largeur nettement inférieure à 10 µm, ce qui est bien inférieur à la dimension minimum que l'on sait actuellement réaliser en utilisant des scies. Notamment, dans le domaine de la gravure plasma, on peut couramment procéder à la gravure d'évidements dont les dimensions minimales sont nettement inférieures au micromètre, mais pouvant aller jusqu'à quelques micromètres, et la profondeur des évidements formés peut s'étendre sur des profondeurs de l'ordre de quelques micromètres mais allant jusqu'à quelques centaines de micromètres.

On comprendra donc que la présente invention offre de nombreuses applications dans divers domaines et notamment dans le domaine de la microélectronique.

Les protubérances 15 pourront prendre la forme de nervures rectilignes si l'on veut former des évidements 21 en forme de tranchées rectilignes. Les protubérances 15 pourront également prendre la forme des pions circulaires, ou de toute forme choisie, centrés sur des ouvertures correspondantes 13 formés dans le masque 12 ; les évidements 21 auront alors la forme de troncs de cône inversés.

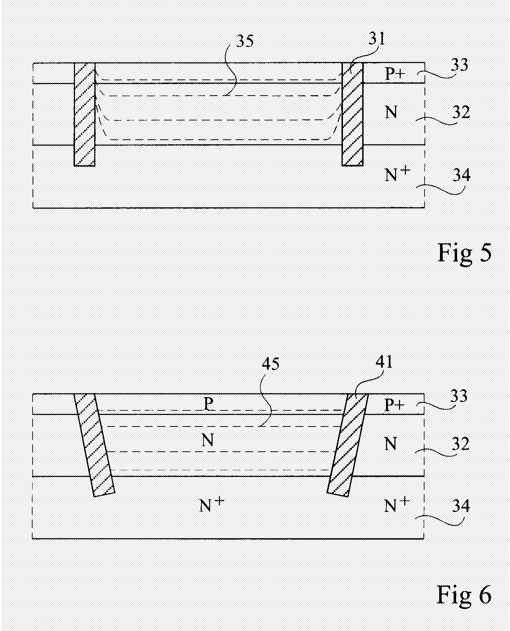

Les figures 5 et 6 illustrent un exemple d'application de la présente invention à la réalisation d'une diode haute tension verticale, la figure 5 illustrant une structure classique et la figure 6 illustrant une structure selon la présente invention. La diode est formée à partir d'un substrat 32 faiblement dopé de type N dont la face supérieure comprend une région 33 dopée de type P et dont la face inférieure comprend une région 34 fortement dopée de type N. Une zone active est délimitée par une tranchée 31 dont les parois sont revêtues d'un isolant, par exemple de l'oxyde de silicium. La tranchée 31 traverse la couche P 33 et, au moins partiellement, le substrat 32. Une métallisation de cathode non représentée est formée sur la face inférieure et une métallisation d'anode non représentée est formée sur la face supérieure sur la zone active.

Une des caractéristiques importantes des diodes haute tension est qu'elles doivent résister à une tension importante appliquée en inverse. Cette tension est essentiellement supportée par le substrat faiblement dopé 32. Les équipotentielles, représentées par des pointillés, s'étendent sensiblement horizontalement et se répartissent principalement dans la couche 32. Toutefois, dans le cas classique illustré en figure 5, on s'aperçoit qu'il survient une courbure des équipotentielles 35 au niveau de leur périphérie. Ainsi, les équipotentielles sont plus rapprochés les unes des autres au niveau de la périphérie du composant, au voisinage de la tranchée verticale 31, que dans la partie centrale. L'épaisseur de la couche de type N 32 doit donc être supérieure à son épaisseur théorique pour permettre de supporter la tension sans claquage au niveau de la périphérie du composant.

Si, comme l'illustre la figure 6, au lieu d'une tranchée verticale telle que la tranchée 31, on utilise une tranchée oblique 41 selon la présente invention, les équipotentielles 36 deviennent horizontales même dans la région périphérique. La diode aura une meilleure tenue en tension et l'épaisseur choisie pour la région de type N faiblement dopée pourra être proche de sa valeur théorique. Comme on l'a indiqué précédemment, la tranchée oblique périphérique pourra être réalisée en une ou plusieurs étapes. Elle pourra également être constituée d'une succession de perçages voisins (à la manière de pointillés) se rejoignant à la suite d'une étape d'oxydation.

Plus généralement on pourra former une tranchée en prévoyant une suite d'évidements voisins, les intervalles entre évidements étant spécifiquement traités, par exemple en réalisant à partir de ces évidements des régions spécifiquement diffusées et/ou oxydées se rejoignant d'un évidement à l'évidement adjacent.

Ceci ne constitue qu'un exemple d'application de la présente invention. De nombreux autres exemples apparaîtront à l'homme de l'art. Par exemple, on pourra utiliser des tranchées fortement obliques se rejoignant à l'intérieur du substrat pour délimiter des zones isolées dans le substrat. On pourra aussi réaliser des vias obliques pour résoudre des problèmes topologiques de connectique.

## Revendications

1. Procédé de formation d'un évidement oblique (21) de dimension minimale en coupe inférieure à 10 µm dans une plaquette disposée dans un réacteur de gravure plasma dans lequel le plasma s'étend le long de la surface de la plaquette, **caractérisé en ce qu'**il consiste à former des discontinuités dans le contour du plasma et de sa gaine au voisinage immédiat de la plaquette dans des zones où l'on souhaite former des évidements délimités par des ouvertures (13) dans un masque de protection (12) à la surface de la plaquette.

2. Procédé selon la revendication 1, consistant à former des protubérances (15) d'une hauteur supérieure à environ 100 µm sur la plaquette.

3. Procédé selon la revendication 2, dans lequel les protubérances résultent du dépôt et de la gravure d'une couche.

4. Procédé selon la revendication 3, dans lequel la plaquette est une plaquette de silicium.

5. Procédé selon la revendication 4, dans lequel les protubérances correspondent à des zones délimitées par des tranchées formées dans une plaquette de silicium elle-même posée sur la plaquette à graver.

6. Procédé selon la revendication 1, dans laquelle l'évidement a une profondeur de 10 à 300 µm.

7. Structure obtenue par le procédé selon la revendication 4, constituant une puce semiconductrice et comprenant une tranchée oblique ou une pluralité de tranchées obliques qui délimitent un composant semiconducteur.

8. Structure selon la revendication 7, constituant une puce semiconductrice et comprenant une tranchée oblique ou une pluralité de tranchées obliques qui délimitent un composant semiconducteur, ladite tranchée étant constituée d'une suite d'évidements voisins et les intervalles entre évidements étant spécifiquement traités.

9. Structure selon la revendication 7, constituant une diode.

10. Structure obtenue par le procédé selon la revendication 4, dans laquelle l'évidement constitue un via.
